# EUROPEAN PATENT SPECIFICATION

(11) **EP 1 069 682 B1**
(45) Date of publication and mention of the grant of the patent: **31.05.2006**
(21) Application number: 00305781.7
(22) Date of filing: 07.07.2000
(51) Int. Cl.: H03J 5/24, H03F 3/191

(54) **Switchable buffer circuit**
Umschaltbare Pufferschaltung
Circuit tampon commutable

(30) Priority: 12.07.1999 JP 19800499; 26.01.2000 JP 2000017368
(43) Date of publication of application: 17.01.2001
(73) Proprietor: ALPS ELECTRIC CO., LTD., Ota-ku Tokyo 145 (JP)
(72) Inventor: Noumi, Hiroki, c/o Alps Electric Co. Ltd, Tokyo 145 (JP); Baba, Toshiki, c/o Alps Electric Co. Ltd, Tokyo 145 (JP)
(74) Representative: Kensett, John Hinton

(56) References cited:
- EP-A- 0 845 855
- DE-B- 1 286 081
- US-A- 5 758 276

## Description

The present invention relates to a frequency characteristic switchable buffer circuit, and more particularly, to a frequency characteristic switchable buffer circuit for outputting a selected frequency signal component in a state in which a not selected frequency signal component is sufficiently attenuated by providing signals of a first frequency and a second frequency, which are selectively supplied, with excellent frequency selecting characteristics, respectively.

Mobile communication systems used in respective countries in the world include a digital cellular system (DCS), which is used in Great Britain, Germany, Italy, France and some countries in Asia and a global system for mobile communications (GSM), which is a unified European standard system for digital portable telephones adopted in 1982 and is used in Europe, USA, Africa and some countries in Asia.

DCS is a mobile communication system in which frequencies of 1805 MHz to 1880 MHz are allocated as a base station frequency, frequencies of 1710 MHz to 1785 MHz are allocated as a mobile station frequency, a 1700 MHz band is allocated as oscillation frequencies of a voltage-controlled oscillator (VCO) of portable telephone sets, 374 channels are used, and a Gaussian minimum shift keying (GMSK) is used as a modulation system. Whereas, GSM is a mobile communication system in which frequencies of 925 MHz to 960 MHz are allocated as a base station frequency, frequencies of 880 MHz to 915 MHz are allocated as a mobile station frequency, a 900 MHz band is allocated as oscillation frequencies of a voltage-controlled oscillator (VCO) of portable telephone sets, 124 channels are used, and the Gaussian minimum shift keying (GMSK) is used as a modulation system.

Since these two mobile communication systems, that is, the DCS system and the GSM system are intrinsically mobile communication systems employing a different system, two portable telephone sets, that is, a portable telephone set used to carry out mobile communication through DCS and a portable telephone set used to carry out mobile communication through GSM are necessary to become a subscriber of both the DCS and GSM mobile communication systems.

A receiver with a buffer in which a parallel resonant circuit at the output and a low-pass filter at the input are switched to operate in two frequency bands is known from the document US-5-758-276.

Both DCS and GSM employ GMSK as the modulation system thereof and are different from each other only in that they use different frequencies allocated thereto. Thus, there has been proposed a portable telephone set applicable to both of DCS and GSM. This portable telephone set is provided with a switching type oscillator which includes two voltage-controlled oscillators, that is, a first voltage-controlled oscillator for oscillating a first frequency of the 1700 MHz band, a second voltage-controlled oscillator for oscillating a second frequency of the 900 MHz band and a switching circuit so that the portable telephone set can separately use the two voltage-controlled oscillators by controlling the switching circuit of the switching type oscillator.

When the portable telephone set, which can be used in both of DCS and GSM, carries out mobile communication through DCS, the first voltage-controlled oscillator is switched to an operating state and the second voltage-controlled oscillator is switched to a non-operating state by the switching circuit and an oscillation signal of a first frequency is output from the first voltage-controlled oscillator. In contrast, when the portable telephone set, which can be used in both of DCS and GSM, carries out mobile communication through GSM, the second voltage-controlled oscillator is switched to an operating state and the first voltage-controlled oscillator is switched to a non-operating state by the switching circuit and an oscillation signal of a second frequency is output from the second voltage-controlled oscillator. Then, the oscillation signal of the first frequency and the oscillation signal of the second frequency are selectively amplified by a frequency characteristic switchable buffer circuit and then supplied to a circuit where it is used.

The frequency characteristic switchable buffer circuit which is used at that time includes a parallel resonant circuit (frequency selection circuit). When the first voltage-controlled oscillator is in operation or the second voltage-controlled oscillator is in operation, a first switching voltage or a second switching voltage is supplied to the parallel resonant circuit so that the frequency selecting characteristics thereof are switched. When the first switching voltage is supplied to the parallel resonant circuit, it selects the oscillation signal of the first frequency and causes the first voltage-controlled oscillator to output it, whereas when the second switching voltage is supplied to the parallel resonant circuit, it selects the oscillation signal of the second frequency and causes the second voltage-controlled oscillator to output it.

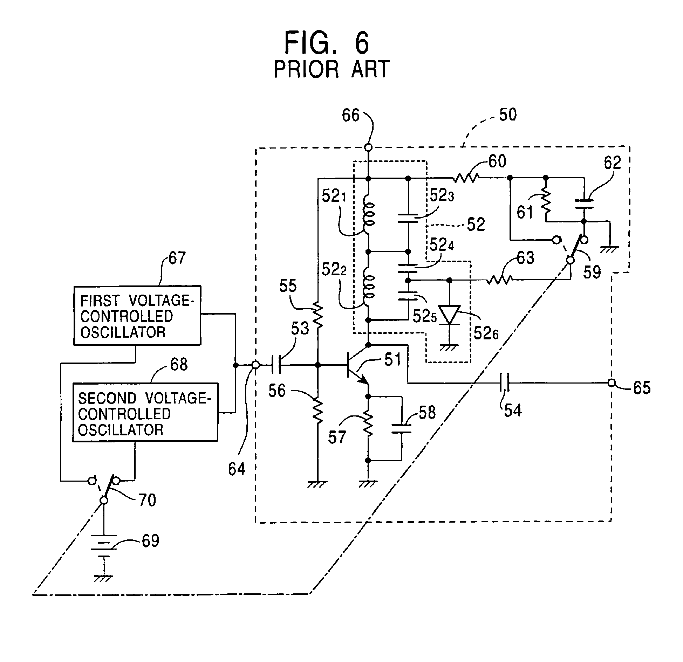

Fig. 6 is a circuit diagram showing an example of an arrangement of a conventional frequency characteristic switchable buffer circuit which is used in a portable telephone set which is can be used in both of DCS and GSM.

As shown in Fig. 6, the conventional frequency characteristic switchable buffer circuit 50 includes a transistor 51, a parallel resonant circuit (frequency selection circuit) 52, coupling capacitors 53 and 54, base bias resistors 55 and 56, an emitter resistor 57, a bypass capacitor 58, a one-circuit two-contacts changeover switch 59, a switching voltage setting resistors 60 and 61, a bypass capacitor 62, a buffer resistor 63, a signal input terminal 64, a signal output terminal 65, and a power supply terminal 66. These circuit elements 51 to 66 are connected as shown in Fig. 6.

The parallel resonant circuit 52 is composed of a first inductor 52₁, a second inductor 52₂, a first capacitor 52₃, a second capacitor 52₄, a third capacitor 52₅, and a switching diode 52₆, and these circuit elements 52₁ to 52₆ are connected as shown in Fig. 6.

Further, as shown in Fig. 6, disposed in the former stage of the frequency characteristic switchable buffer circuit 50 are a first voltage-controlled oscillator 67 for oscillating a first frequency, in this case, a frequency of a 1700 MHz band, a second voltage-controlled oscillator 68 for oscillating a second frequency, in this case, a frequency of a 900 MHz band, a power supply 69, and a one-circuit two-contacts changeover switch 70. These circuit elements 67 to 70 are connected as shown in Fig. 6. In this case, the changeover switches 59 and 70 are switched in association with each other in response to a control signal which will be described later.

The conventional frequency characteristic switchable buffer circuit 50 arranged as described above will operate as described below.

When the portable telephone set is used in the mobile communication through DCS, the respective movable contacts of the changeover switches 59 and 70 are switched from the positions shown by solid lines to the positions shown by dotted lines shown in Fig. 6 in response to a first control signal supplied from a controller (not shown). With this switching operation, the first voltage-controlled oscillator 67 is connected to the power supply 69 and put into an operating state and a signal of the first frequency (frequency of the 1700 MHz band) is supplied from the first voltage-controlled oscillator 67, whereas the second voltage-controlled oscillator 68 is isolated from the power supply 69 and put into a non-operating state. Further, since the movable contact of the changeover switch 59 is switched to the position shown by the dotted line, a first positive switching voltage is supplied to the parallel resonant circuit 52 so that the parallel resonant circuit 52 performs a parallel resonance at the first frequency (frequency of the 1700 MHz band) as described below.

At that time, when the signal of the first frequency (frequency of the 1700 MHz band) output from the first voltage-controlled oscillator 67 is supplied to the signal input terminal 64 and then is amplified by the emitter-grounded transistor 51, only the signal of the first frequency (frequency of the 1700 band) is selectively amplified by the parallel resonant circuit 52 which is connected to the transistor 51 as a load thereon and in parallel resonance with the first frequency (frequency of the 1700 MHz band). Then, the thus amplified signal of the first frequency (frequency of the 1700 band) is supplied from the signal output terminal 65 to the circuit where it is used.

On the other hand, when the portable telephone set is used in the mobile communication through GSM, the respective movable contacts of the changeover switches 59 and 70 are switched to the positions shown by the solid lines in Fig. 6 in response to a second control signal supplied from the controller in the same manner. With this switching operation, the second voltage-controlled oscillator 68 is connected to the power supply 69 and put into an operating state and a signal of the second frequency (frequency of the 900 MHz band) is supplied from the second voltage-controlled oscillator 68, whereas the first voltage-controlled oscillator 67 is isolated from the power supply 69 and put into a non-operating state. Further, since the movable contact of the changeover switch 59 is switched to the position shown by the solid line, a second ground switching voltage is supplied to the parallel resonant circuit 52 so that the parallel resonant circuit 52 performs a parallel resonance at the second frequency (frequency of the 900 MHz band) as described below.

At that time, when the signal of the second frequency (frequency of the 900 MHz band) output from the second voltage-controlled oscillator 68 is supplied to the signal input terminal 64 and then amplified by the emitter-grounded transistor 51, only the signal of the second frequency (frequency of the 900 MHz band) is selectively amplified by the parallel resonant circuit 52 which is connected to the transistor 51 as a load thereon and in parallel resonance with the second frequency (frequency of the 900 MHz band). Then, the thus amplified signal of the second frequency (frequency of the 900 MHz band) is supplied from the signal output terminal 65 to the circuit where it is used.

Next, operation for switching the parallel resonant frequency of the parallel resonant circuit 52 to the first frequency or to the second frequency by supplying a first switching signal or a second switching signal to the parallel resonant circuit 52.

First, when the parallel resonant circuit 52 is caused to perform a parallel resonance with the signal of the second frequency (frequency of the 900 MHz band) by supplying the second ground switching voltage thereto, the switching diode 52₆ is turned off in response to the second ground switching voltage supplied to the parallel resonant circuit 52, whereby the connecting point where the second capacitor 52₄ is connected to the third capacitor 52₅ is isolated from ground. At that time, a parallel resonant frequency, which is approximate equal to the second frequency (frequency of the 900 MHz band) is set to the parallel resonant circuit 52 by a first parallel connecting circuit, which is composed of the first inductor 52₁ and the first capacitor 52₃, and by a second parallel connecting circuit, which is composed of the second inductor 52₂ which is connected in series to the first parallel connecting circuit and of the second capacitor 52₄ and the third capacitor 52₅ which are connected in series to the first parallel connecting circuit. In the above parallel resonance, the second parallel connecting circuit exhibits a minute capacitor at the second frequency (frequency of the 900 MHz band) and the parallel resonant circuit 52 is arranged as an equivalent circuit which is composed of a series circuit including the first inductor 52₁ and the minute capacitor and of the first capacitor 52₃ connected in parallel to the first inductor 52₁, whereby a parallel resonant frequency of the parallel resonant circuit 52 can easily be set to the second frequency (frequency of the 900 MHz band).

Next, when the parallel resonant circuit 52 is caused to perform a parallel resonance with the signal of the first frequency (frequency of the 1700 MHz band) by supplying the first positive switching voltage to the parallel resonant circuit 52, the switching diode 52₆ is turned on in response to the first positive switching voltage supplied to the parallel resonant circuit 52, whereby the connecting point where the second capacitor 52₄ is connected to the third capacitor 52₅ is connected to ground. At that time, a parallel resonant frequency, which is approximate equal to the first frequency (frequency of the 1700 MHz band) is set to the parallel resonant circuit 52 by the second inductor 52₂ and by the second capacitor 52₄ and the third capacitor 52₅ which are connected in parallel to the second inductor 52₂. This is because that the second inductor 52₂ is connected to ground on the side thereof connected to the first inductor 52₁ through the second capacitor 52₄ and the switching diode 52₆ having been turned on so that the first parallel connecting circuit composed of the second inductor 52₂ and the first capacitor 52₃ can be ignored. In the above parallel resonance, the parallel connecting circuit including the second capacitor 52₄ and the third capacitor 52₅ exhibit a synthetic capacitor and the parallel resonant circuit 52 is arranged as an equivalent capacitor composed of the second inductor 52₂ and the synthetic capacitor which are connected thereto in parallel therewith. Accordingly, a parallel resonant frequency of the parallel resonant circuit 52 can be easily set to the first frequency (frequency of the 1700 MHz band)

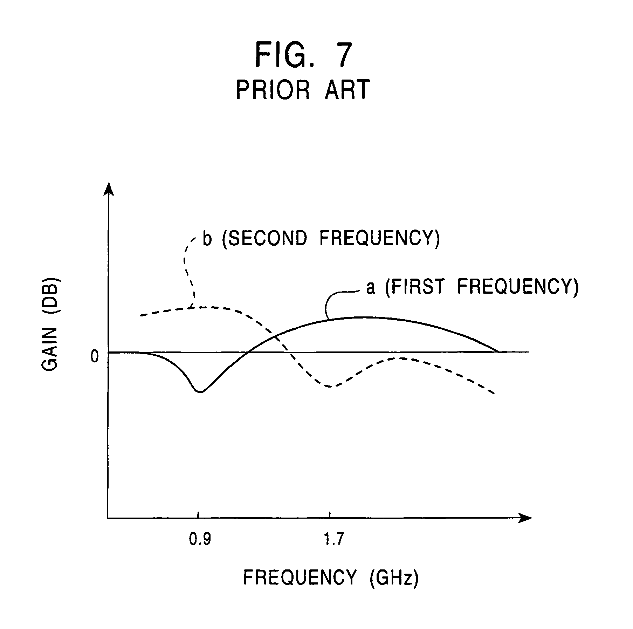

Fig. 7 is a characteristic view showing an example of characteristics between gain and frequency in the conventional frequency characteristic switchable buffer circuit 50 shown in Fig. 6.

In Fig. 7, the abscissa shows frequency (unit: GHz) and the ordinate shows gain (unit: dB). A curve (solid line) a shows characteristics when the buffer circuit 50 performs a parallel resonance at the first frequency of the 1.7 GHz (1700 MHz band), whereas a curve b shows characteristics when the buffer circuit 50 is tuned for the second frequency of the 0.9 GHz (900 MHz band).

As shown by the curves a and b of Fig. 7, when the signal of the first frequency (frequency of the 1700 MHz band) is selected as an amplifying signal, the buffer circuit 50 has a large gain with respect to the signal of the first frequency, whereas when the signal of the second frequency (frequency of the 1700 MHz band) is selected as the amplifying signal, the buffer circuit 50 has a large gain with respect to the signal of the second frequency.

When the signal of the first frequency (frequency of the 1700 MHz band) is selected as the amplifying signal, since the conventional frequency characteristic switchable buffer circuit 50 has the large gain with respect to the signal of the first frequency, the buffer circuit 50 can take out the signal of the first frequency which has a large signal amplitude. Whereas, when the signal of the second frequency (frequency of 900 MHz band) is selected as the amplifying signal, since the frequency characteristic switchable buffer circuit 50 has the large gain with respect to the signal of the second frequency, the buffer circuit 50 can take out the signal of the second frequency which has a large signal amplitude in the same manner.

However, when the signal of the first frequency (frequency of the 1700 MHz band) is selected, the conventional frequency characteristic switchable buffer circuit 50 cannot obtain a so large amount of attenuation with respect to a signal on the side of a frequency which is higher than the first frequency. Accordingly, there is an increased possibility that a signal of a frequency which is spurious to the first frequency is output simultaneously with the output of the signal of the first frequency. Further, when the signal of the second frequency (frequency of 900 MHz band) is selected, the buffer circuit 50 cannot obtain a so large amount of attenuation of the harmonics component of the signal of the second frequency. Accordingly, there is an increased possibility that a signal of a spurious frequency is output simultaneously with the output of the signal of the second frequency.

An object of the present invention, which was made in view of the above technological background, is to provide a frequency characteristic switchable buffer circuit capable of increasing an amount of attenuation of a signal of a spurious frequency when a signal of a first frequency is selected and capable of increasing an amount of attenuation of a signal of a spurious frequency when a signal of a second frequency is selected.

To achieve the above object, a frequency characteristic switchable buffer circuit of the present invention has a first arrangement in which the buffer circuit includes an amplifier stage, a parallel resonant circuit which acts as an output load on the amplifier stage, a frequency trap circuit connected between the input of the amplifier stage and a reference potential, and a frequency switching voltage generator for selectively generating a first switching voltage and a second switching voltage, wherein the parallel resonant circuit performs a parallel resonance at a first frequency when the first switching voltage is supplied and performs a parallel resonance at a second frequency which is different from the first frequency when the second switching voltage is supplied, the frequency trap circuit is composed of a series circuit including a diode and a capacitor and performs a series resonance at the second frequency when the first switching voltage is supplied and performs a series resonance at the first frequency when the second switching voltage is supplied.

In the first arrangement, the first switching voltage is supplied to the parallel resonant circuit, and the parallel resonant circuit is caused to perform a parallel resonance at the first frequency so as to selectively output a signal of the first frequency. At that time, when the first switching voltage is supplied also to the frequency trap circuit so that the frequency trap circuit is caused to perform a series resonance at a frequency which is lower than the first frequency so as to form a trap to the low frequency as well as when a trap is generated to the side of a frequency which is higher than the first frequency by the rebound of the formation of the above trap, the signal component of the spurious frequency of the signal of the first frequency is attenuated by these traps. On the other hand, the second switching voltage is supplied to the parallel resonant circuit, the parallel resonant circuit is caused to perform a parallel resonance at the second frequency so as to selectively output a signal of the second frequency. At that time, when the second switching voltage is supplied also to the frequency trap circuit so that the frequency trap circuit is caused to perform a series resonance at a frequency in the vicinity of 1700 MHz so as to generate a trap to the frequency in the vicinity of 1700 MHz, the signal component of the spurious frequency of the second frequency signal is attenuated by the trap. As described above, when signal of the first frequency is selected, an amount of attenuation of the signal component of the spurious frequency of the signal of the first frequency can be increased. In addition, when the signal of the second frequency is selected, an amount of attenuation of the signal component of the spurious frequency of the signal of the second frequency also can be increased. Accordingly, there can be obtained an effect that the first frequency signal and the second frequency signal in which almost no spurious signal contained can be selectively output.

Preferably, an inductor is connected in series to the series circuit including the diode and the capacitor and in which an additional capacitor is connected in parallel to the diode.

When the first switching voltage is supplied to the frequency trap circuit so as to make the diode conductive as well as when the frequency trap circuit is caused to perform a series resonance at a frequency in the vicinity of 900 MHz through the capacitor and the diode by adjusting a capacitance value of the capacitor and an inductance value of the inductor, not only the signal component of the spurious frequency of the first frequency is attenuated but also a trap is generated on the side of a frequency which is higher than the first frequency by the rebound of the attenuation, and the thus generated trap attenuates the signal component of the spurious frequency of the first frequency. On the other hand, when the second switching voltage is supplied to the frequency trap circuit so as to make the diode nonconductive as well as when the frequency trap circuit is caused to perform a series resonance at a frequency in the vicinity of 1700 MHz through the capacitor and the diode by adjusting a capacitance value of the capacitor and an inductance value of the inductor, an amount of attenuation of the signal of the spurious frequency of the signal of the second frequency can be greatly increased as compared with an amount of attenuation of the signal in the first arrangement, whereby the first frequency signal and the second frequency signal in which almost no spurious signal component is contained can be selectively output.

Further, it is preferable that the first frequency be supplied from a first oscillator and the second frequency be supplied from a second oscillator, the first oscillator and the second oscillator be alternately switched to an operating state and to a non-operating state, and when the first oscillator is in the operating state, the frequency switching voltage generator be switched to generate the first switching voltage, and when the second oscillator is in the operating state, the frequency switching voltage generator be switched to generate the second switching voltage.

With the above arrangement, since the first oscillator generates the first frequency and the second oscillator generates the second frequency, it is possible to set the first frequency and the second frequency in an arbitrary frequency range. As a result, a range of a technology, to which the frequency characteristic switchable buffer circuit is applied, can be increased.

In addition to the above, it may be arranged such that the second frequency and the first frequency have a relationship of a basic wave frequency and its harmonic frequency, the second frequency is directly supplied from an oscillator and the first frequency is supplied from a harmonic oscillator to which the second frequency is imposed, when the first frequency is supplied from the oscillator, the frequency switching voltage generator is switched to output the first switching voltage, and when the second frequency is supplied from the harmonic oscillator, the frequency switching voltage generator is switched to output the second switching voltage.

With the above arrangement, the first frequency and the second frequency can be selectively supplied to the frequency characteristic switchable buffer circuit only by a single oscillator, whereby a manufacturing cost can be reduced.

Embodiments of the present invention, will now be described, by way of example only, with reference to the accompanying diagrammatic drawings, in which:
Fig. 1 is a circuit arrangement diagram showing a first embodiment of a frequency characteristic switchable buffer circuit according to the present invention;
Fig. 2 is an equivalent circuit diagram when a first or second switching signal is supplied to a frequency trap circuit shown in Fig. 1;
Fig. 3 is a characteristic view showing characteristics between gain and frequency in the frequency characteristic switchable buffer circuits according to first to third embodiments of the present invention;
Fig. 4 is a circuit arrangement diagram showing the second embodiment of the frequency characteristic switchable buffer circuit according to the present invention;
Fig. 5 is a circuit arrangement diagram showing the third embodiment of the frequency characteristic switchable buffer circuit according to the present invention;
Fig. 6 is a circuit arrangement diagram showing an example of a conventional frequency characteristic switchable buffer circuit; and
Fig. 7 is a characteristic view showing characteristics between gain and frequency in the frequency characteristic switchable buffer circuit shown in Fig. 6.

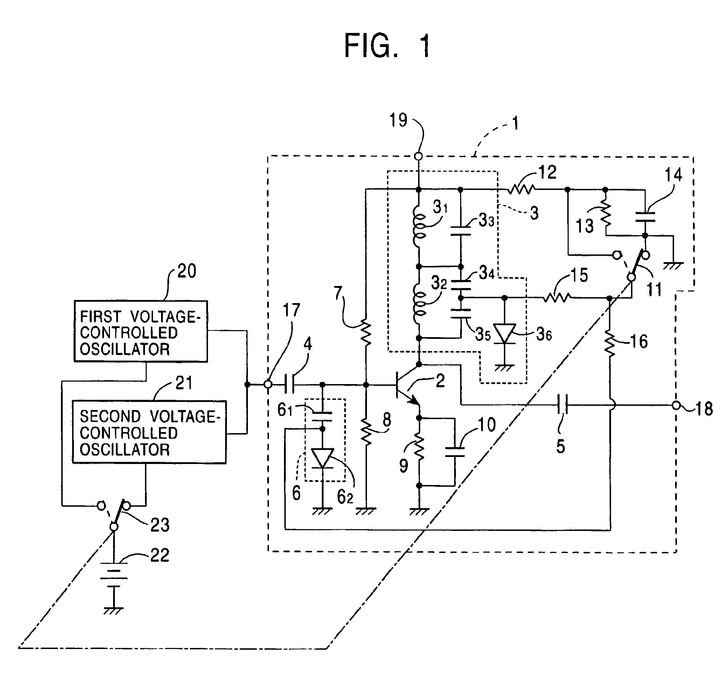

Fig. 1 is a circuit arrangement diagram showing a first embodiment of a frequency characteristic switchable buffer circuit wherein shown is an example in which the buffer circuit is used in a portable telephone set which can be used in both of DCS and GSM.

As shown in Fig. 1, the frequency characteristic switchable buffer circuit 1 of the first embodiment includes a transistor 2, a parallel resonant circuit (frequency selection circuit) 3, coupling capacitors 4 and 5, a frequency trap circuit 6, base bias resistors 7 and 8, an emitter resistor 9, a bypass capacitor 10, a one-circuit two-contacts changeover switch 11, a switching voltage setting resistors 12 and 13, a bypass capacitor 14, buffer resistors 15 and 16, a signal input terminal 17, a signal output terminal 18, and a power supply terminal 19. These circuit elements 1 to 19 are connected as shown in Fig. 1.

The parallel resonant circuit 3 includes a first inductor 3₁, a second inductor 3₂, a first capacitor 3₃, a second capacitor 3₄, a third capacitor 3₅, and a first switching diode 3₆. Further, the frequency trap circuit 6 includes a fourth capacitor 6₁, and a second switching diode 6₂. These circuit elements 3₁ to 3₆ and 6₁ and 6₂ are connected as shown in Fig. 1.

In this case, an inductance of the first inductor 3₁ is selected so that it is larger than an inductance of the second inductor 3₂ of the parallel resonant circuit 3. Further, a capacitance of the third capacitor 3₅ is selected so that it is considerably larger than a capacitance of the second capacitor 3₄, for example, so that the capacitance of the second capacitor 3₄ is set to about 2 pF when the capacitance of the third capacitor 3₅ is 1000 pF.

Further, as shown in Fig. 1, disposed in the former stage of the frequency characteristic switchable buffer circuit 1 are a first voltage-controlled oscillator 20 for oscillating a first frequency, in this case, a frequency of a 1700 MHz band, a second voltage-controlled oscillator 21 for oscillating a second frequency, in this case, a frequency of the 900 MHz band, a power supply 22, and a one-circuit two-contacts changeover switch 23. These circuit elements 20 to 23 are connected as shown in Fig. 1. In this case, the changeover switches 11 and 23 are switched in association with each other in response to a control signal which will be described later.

Incidentally, the frequency characteristic switchable buffer circuit 1 of the first embodiment (hereinafter, referred to as the buffer circuit 1 of the first embodiment) is arranged similarly to the conventional frequency characteristic switchable buffer circuit 50 shown in Fig. 6 (hereinafter, referred to as the conventional buffer circuit 50) except the following arrangement. That is, the buffer circuit 1 of the first embodiment is provided with the frequency trap circuit 6 and selectively supplies a first switching voltage or a second switching voltage to the second switching diode 6₂ of the frequency trap circuit 6 in relation to the provision of the frequency trap circuit 6, whereas the conventional buffer circuit 50 is not provided with the frequency trap circuit 6.

The parallel resonant circuit 3 of the buffer circuit 1 of the first embodiment is arranged similarly to the parallel resonant circuit 52 of the conventional buffer circuit 50. Thus, the operation which is performed when the first switching voltage or the second switching voltage is supplied to the parallel resonant circuit 3 of the buffer circuit 1 of the first embodiment is the same as operation performed when the first switching voltage or the second switching voltage is supplied to the parallel resonant circuit 52 of the conventional buffer circuit 50 which was described above.

Therefore, in the following description, the description of the operation of the conventional buffer circuit 50 when the first switching voltage or the second switching voltage is supplied to the parallel resonant circuit 52 of the buffer circuit 50 will be invoked to the description of the operation of the buffer circuit 1 of the first embodiment, and the description of the operation of the buffer circuit 1 when the first switching voltage or the second switching voltage is supplied to the parallel resonant circuit 3 of the buffer circuit 1 is omitted.

The frequency characteristic switchable buffer circuit 1 of the first embodiment arranged as described above will operate as described below.

When the portable telephone set is used in the mobile communication through DCS, the respective movable contacts of the changeover switches 11 and 23 are switched from the positions shown by solid lines to the positions shown by dotted lines shown in Fig. 1 in response to a first control signal supplied from a controller (not shown). With the switching operation of the movable contact of the changeover switch 23 to the position of the dotted line, the first voltage-controlled oscillator 20 is connected to the power supply 22 and put into an operating state and a signal of the first frequency (frequency of the 1700 MHz band) is supplied from the first voltage-controlled oscillator 20, whereas the second voltage-controlled oscillator 21 is isolated from the power supply 69 and put into a non-operating state. Further, since the movable contact of the changeover switch 11 is switched to the position shown by the dotted line, a first positive switching voltage is supplied to the parallel resonant circuit 3 so that the parallel resonant circuit 3 performs a parallel resonance at the first frequency as described above. At the same time, the first positive switching voltage is supplied to the frequency trap circuit 6 so that the frequency trap circuit 6 performs a series resonance at the second frequency (frequency of 900 MHz band as described below).

When the signal of the first frequency output from the first voltage-controlled oscillator 20 is supplied to the signal input terminal 17 and then amplified by the emitter-grounded transistor 2, only the signal of the first frequency is selectively amplified by the parallel resonant circuit 3 which is connected to the transistor 2 as a collector load thereof and performs a parallel resonance at the first frequency. Then, the thus amplified signal of the first frequency is supplied to a circuit where it is used through the signal output terminal 18. At that time, the frequency trap circuit 6, which performs a series resonance at a frequency (for example, frequency of the 900 MHz band) which is lower than the first frequency (frequency of the 1700 MHz band), is connected between the base of the transistor 2 and the ground. Thus, when the frequency trap circuit 6 is caused to perform a series resonance at the low frequency (frequency of the 900 MHz band), a trap resulting from the rebound of the series resonance is generated on the side of a frequency which is higher than the first frequency (frequency of the 1700 MHz band), whereby the signal component of a spurious frequency contained in the signal of the first frequency is sufficiently attenuated. As a result, only the signal of the first frequency which does not contain the signal component of the spurious frequency can be supplied to the signal output terminal 18.

On the other hand, when the portable telephone set is used in the mobile communication through GSM, the respective movable contacts of the changeover switches 11 and 23 are switched to the positions shown by the solid lines in Fig. 1 in response to a second control signal supplied from the controller in the same manner. With the switching operation of the movable contact of the changeover switch 23 to the position of the solid line, the second voltage-controlled oscillator 21 is connected to the power supply 22 and put into an operating state and a signal of the second frequency (frequency of the 900 MHz band) is supplied from the second voltage-controlled oscillator 21, whereas the first voltage-controlled oscillator 20 is isolated from the power supply 22 and put into a non-operating state. Further, since the movable contact of the changeover switch 11 is switched to the position shown by the solid line, a second ground switching voltage is supplied to the parallel resonant circuit 3 so that the parallel resonant circuit 3 performs a parallel resonance at the second frequency as described below. At the same time, the second ground switching voltage is supplied to the frequency trap circuit 6 so that the frequency trap circuit 6 performs a series resonance at the frequency of the 1700 MHz band.

When the signal of the second frequency output from the second voltage-controlled oscillator 21 is supplied to the signal input terminal 17 and then amplified by the emitter-grounded transistor 2, only the signal of the second frequency is selectively amplified by the parallel resonant circuit 3 which is connected to the transistor 2 as a collector load thereof and performs a parallel resonance at the second frequency. Then, the thus amplified signal of the second frequency is supplied to the circuit where it is used through the signal output terminal 18. At the time, since the frequency trap circuit 6, which performs a series resonance at the first frequency (frequency of the 1700 MHz band), is connected between the base of the transistor 2 and the ground, the spurious signal component contained in the signal of the second frequency is sufficiently attenuated by the frequency trap circuit 6. As a result, it is possible to supply only the signal of the second frequency which does not contain the spurious signal component.

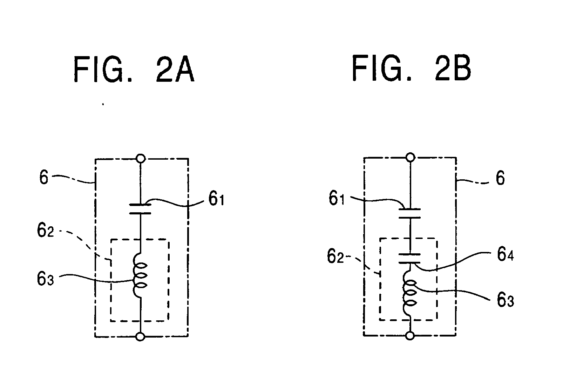

Figs. 2A and 2B show equivalent circuit diagrams when the first or second switching signal is supplied to the frequency trap circuit 6 shown in Fig. 1.

There will be described the operation in which the series resonant frequency of the frequency trap circuit 6 used in the buffer circuit 1 is switched to the first frequency or to the second frequency in response to the first switching signal or the second switching signal supplied to the frequency trap circuit 6 with reference to the equivalent circuit diagrams shown in Figs. 2A and 2B.

First, when the first positive switching voltage is supplied to the frequency trap circuit 6, the second switching diode 6₂ is turned on, whereby only the lead wire inductor 6₃ of the lead wire of the second switching diode 6₂ which acts as the second switching diode 6₂ remains as a circuit element and connected in series to the fourth capacitor 61. At that time, the frequency trap circuit 6 is arranged as a series circuit composed of the fourth capacitor 6₁ and the lead wire inductor 6₃ as shown in Fig. 2A. Accordingly, when the series circuit is caused to perform a series resonance at a frequency (for example, frequency of the 900 MHz band) which is lower than the first frequency (frequency of the 1700 MHz band) by selecting a capacitance value of the fourth capacitor 6₁ and an inductance value of the lead wire inductor 6₃, a trap is generated on the side of a frequency which is higher than the first frequency (frequency of the 1700 MHz band) by the rebound of the above resonance, and the thus generated trap greatly attenuates the spurious high-frequency signal component of the first frequency.

Next, when the second ground switching voltage is supplied to the frequency trap circuit 6, the second switching diode 6₂ is turned off, whereby a series circuit composed of the lead wire inductor 6₃ of the lead wire of the second switching diode 6₂ which acts as the second switching diode 6₂ and the junction capacitor 6₄ of the semiconductor junction of the lead wire inductor 6₃ remains as a circuit element and connected in series to the fourth capacitor 6₁. At that time, the frequency trap circuit 6 is composed of the series circuit including the fourth capacitor 6₁, the lead wire inductor 6₃, and the junction capacitor 6₄ as shown in Fig. 2B. As a result, when the series circuit is caused to perform a series resonance at the first frequency (frequency of 1700 MHz band) by selecting a capacitance value of the fourth capacitor 6₁, an inductance value of the lead wire inductor 6₃, and a capacitance value of the junction capacitor 6₄, the spurious high-frequency signal component of the second frequency (frequency of the 900 MHz band) can be greatly attenuated.

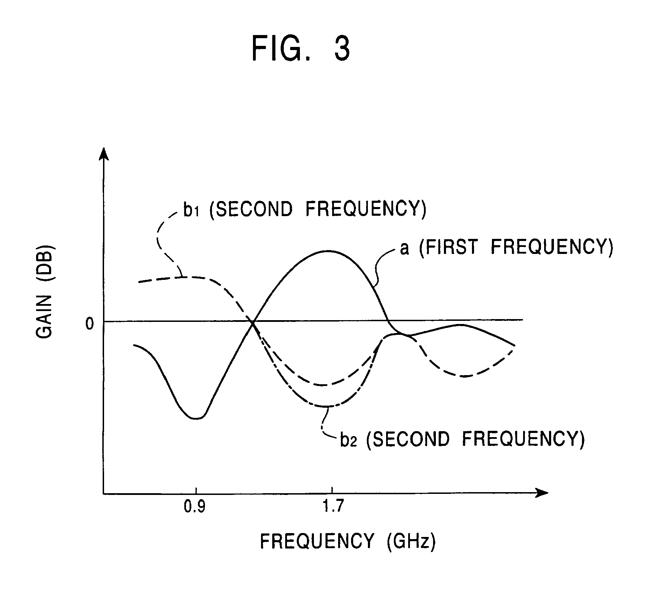

Next, Fig. 3 is a characteristic view showing characteristics between gain and frequency which can be obtained by the buffer circuit 1 of the first embodiment shown in Fig. 1.

In Fig. 3, the abscissa shows frequency (unit: GHz) and the ordinate shows gain (unit: dB). A curve (solid line) a shows characteristics when the parallel resonant circuit 3 of the buffer circuit 1 performs a parallel resonance at the first frequency of the 1.7 GHz band (frequency of the 1700 MHz band) and when a rebound trap is generated by the frequency trap circuit 6 on the side of a frequency which is higher than the first frequency (frequency of the 1700 MHz band). A curve (dotted line) b₁ shows characteristics when the parallel resonant circuit 3 of the buffer circuit 1 performs a parallel resonance at the second frequency of the 0.9 GHz band (frequency of the 900 MHz band) and when the frequency trap circuit 6 performs a parallel resonance at the frequency of the 1.7 GHz band (frequency of the 1700 MHz band).

As shown by the curves a and b1 of Fig. 3, in the comparison of the characteristics obtained by the buffer circuit 1 of the first embodiment with the characteristics obtained by the conventional buffer circuit 50 shown in Fig. 6, when the signal of the first frequency (frequency of the 1700 MHz band) is selected, a gain for the signal of the first frequency is increased and an amount of attenuation of a spurious signal on the side of a frequency which is higher than the first frequency also is greatly increased. On the other hand, when the signal of the second frequency (frequency of the 900 MHz band) is selected, an amount of attenuation of the signal of the frequency of the 1700 MHz band, which is spurious to the second frequency, is greatly increased, while a gain to the signal of the second frequency remains unchanged.

As described above, the buffer circuit 1 of the first embodiment not only can greatly increase an amount of attenuation of the signal component of the spurious frequency of the first frequency when the signal of the first frequency (frequency of the 1700 MHz band) is selected but also can greatly increase an amount of attenuation of the signal component of the frequency of the 1700 MHz band when the signal of the second frequency (frequency of the 900 MHz band) is selected. Therefore, the buffer circuit 1 can selectively output the signal of the first frequency and the signal of the second frequency in which almost no spurious signal component is contained.

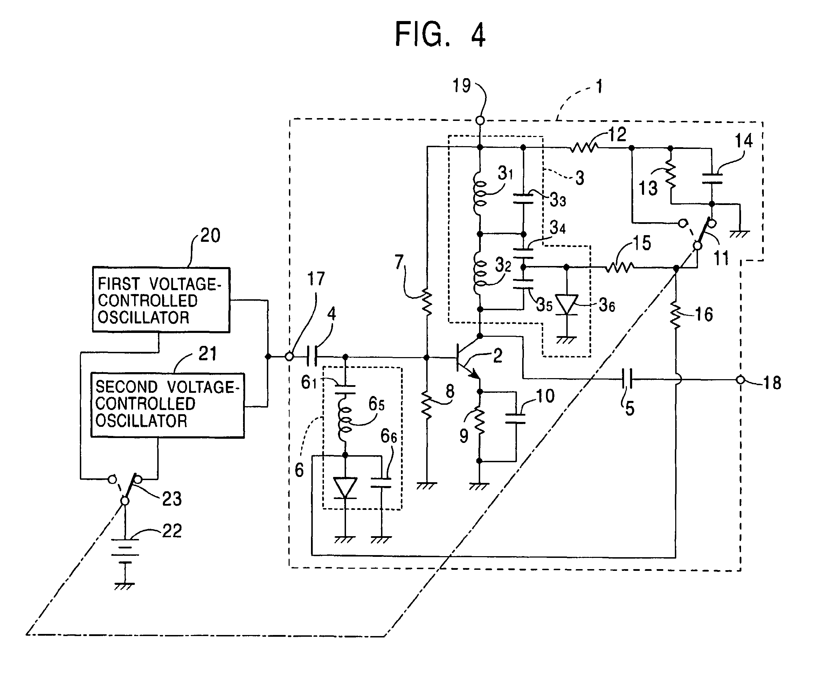

Fig. 4 is a circuit arrangement diagram showing a second embodiment of the frequency characteristic switchable buffer circuit according to the present invention and shows an example in which a frequency trap circuit 6' is arranged differently from the frequency trap circuit 6 of the first embodiment. The second embodiment shows an example in which a buffer circuit is used in a portable telephone set which can be used in both of DCS and GSM similarly to the buffer circuit 1 of the first embodiment.

As shown in Fig. 4, the frequency trap circuit 6' in the buffer circuit 1 of the second embodiment includes a third inductor 6₅ and a fifth capacitor (added capacitor) 6₆, in addition to the fourth capacitor 6₁ and the second switching diode 6₂.

In this case, the third inductor 6₅ is connected in series to the fourth capacitor 6₁ and the second switching diode 6₂, the fifth capacitor 6₆ is connected in parallel to the second switching diode 6₂, and a first switching signal or a second switching signal is supplied to a node where the second switching diode 6₂ is connected to the third inductor 6₅. Further, the buffer circuit 1 of the second embodiment is arranged similarly to the buffer circuit 1 of the first embodiment except the frequency trap circuit 6'.

The buffer circuit 1 of the second embodiment arranged as described above will operate as described below. In this case, since the operation of the buffer circuit 1 of the second embodiment other than the frequency trap circuit 6' is the same as that of the buffer circuit 1 of the first embodiment, only the operation executed by the frequency trap circuit 6' will be described here, and the description of the operation of the components other than the frequency trap circuit 6' will be omitted.

First, when a first positive switching voltage is supplied to the frequency trap circuit 67, the second switching diode 6₂ is turned on, whereby only the lead wire indictor 6₃ of the lead wire of the second switching diode 6₂ which acts as the second switching diode 6₂ remains as a circuit element and is connected in series to the fourth capacitor 6₁ and the third inductor 6₅. Note that since an inductance value of the lead wire inductor 6₃ is considerably smaller than an inductance value of the third inductor 6₅, it may be ignored in this case.

At that time, the frequency trap circuit 6' is arranged as a series circuit composed of the fourth capacitor 6₁ and the third inductor 6₅. Accordingly, when the series circuit is caused to perform a series resonance at a frequency (for example, frequency of the 900 MHz band) which is lower than the first frequency (frequency of the 1700 MHz band) by selecting a capacitance value of the fourth capacitor 6₁ and an inductance value of the third inductor 6₅, a frequency component of the 900 MHz band is trapped so that the frequency component of the 900 MHz band can be greatly attenuated as well as a trap also is generated on the side of a frequency which is higher than the first frequency (frequency of 1700 MHz band) by the rebound of the attenuation, and the thus generated trap can greatly attenuate the spurious high-frequency signal component of the first frequency.

Next, when a second ground switching voltage is supplied to the frequency trap circuit 6', the second switching diode 62 is turned off, whereby a series circuit composed of the lead wire indictor 6₃ of the lead wire of the second switching diode 6₂ which acts as the second switching diode 6₂ and the junction capacitor 6₄ of the semiconductor junction of the lead wire indictor 6₃ remains as a circuit element and connected in series to the fourth capacitor 61 and the third inductor 6₅. Note that since an inductance value of the lead wire inductor 6₃ is considerably smaller than that of the third inductor 65, it may be ignored in this case. Further, since a capacitance value of the junction capacitor 6₄ of the semiconductor junction is considerably smaller than that of the fifth capacitor 6₆, it may be ignored in this case.

At the time, the frequency trap circuit 6 is arranged as a series circuit including the fourth capacitor 6₁, the third inductor 6₅ and the fifth capacitor 6₆. As a result, when the series circuit is caused to perform a series resonance at the first frequency (frequency of the 1700 MHz band) by selecting respective capacitance values of the fourth and fifth capacitors 6₁ and 6₆ and an inductance value of the third inductor 6₅, the frequency component of the 1700 MHz band is trapped and a spurious high-frequency signal component of the second frequency (frequency of the 900 MHz band) can be greatly attenuated.

Incidentally, the buffer circuit 1 of the second embodiment exhibits characteristics between gain and frequency as shown by a curve (dot-dash-line) b₂ of Fig. 3. That is, in the buffer circuit 1 of the second embodiment, a curve a, which shows characteristics between gain and frequency with respect to the first frequency, shows the same characteristics as those shown by the curve a of the buffer circuit 1 of the first embodiment, and the curves b₁ and b₂, which show characteristics between gain and frequency with respect to the second frequency, show the same characteristics as those shown by the curve b₁ of the buffer circuit 1 of the first embodiment except the characteristics in the vicinity of the first frequency (frequency of the 1700 MHz band). More specifically, as to the characteristics in the vicinity of the first frequency (frequency of the 1700 MHz band), an amount of attenuation is greatly increased as shown by the curve b₂ as compared with that shown in the curve b₁.

As described above, the buffer circuit 1 of the second embodiment not only can greatly increase an amount of attenuation of the signal component of the spurious frequency of the first frequency when the signal of the first frequency (frequency of the 1700 MHz band) is selected but also can greatly increase an amount of attenuation of the signal component of the frequency of the 1700 MHz band as compared with the buffer circuit 1 of the first embodiment when the signal of the second frequency (frequency of the 900 MHz band) is selected. Therefore, the buffer circuit 1 can selectively output the signal of the first frequency and the signal of the second frequency in which almost no spurious signal component is contained.

Note that described in the first and second embodiments is the example in which the frequency characteristic switchable buffer circuit 1 is used in the portable telephone set which can be used in both of DCS and GSM, an oscillation signal output from the first voltage-controlled oscillator 20 has a frequency of the 1700 MHz band, and an oscillation signal output from the second voltage-controlled oscillator 21 has a frequency of the 900 MHz band. However, the frequency characteristic switchable buffer circuit 1 in the present invention is limited to the case in which it is used for the portable telephone set described above and may be used for any other similar devices. In such a case, respective oscillation frequencies of the first and second voltage-controlled oscillators 20 and 21 are not limited to the above frequency bands and any other frequency bands may be used so long as they are suitably discrete from each other.

Further, while the first embodiment is described as to the example in which both of the two first and second oscillators are composed of the voltage-controlled oscillators 20 and 21, the two oscillators in the present invention are not limited thereto and oscillators which generate oscillation signals of a fixed frequency band may be used.

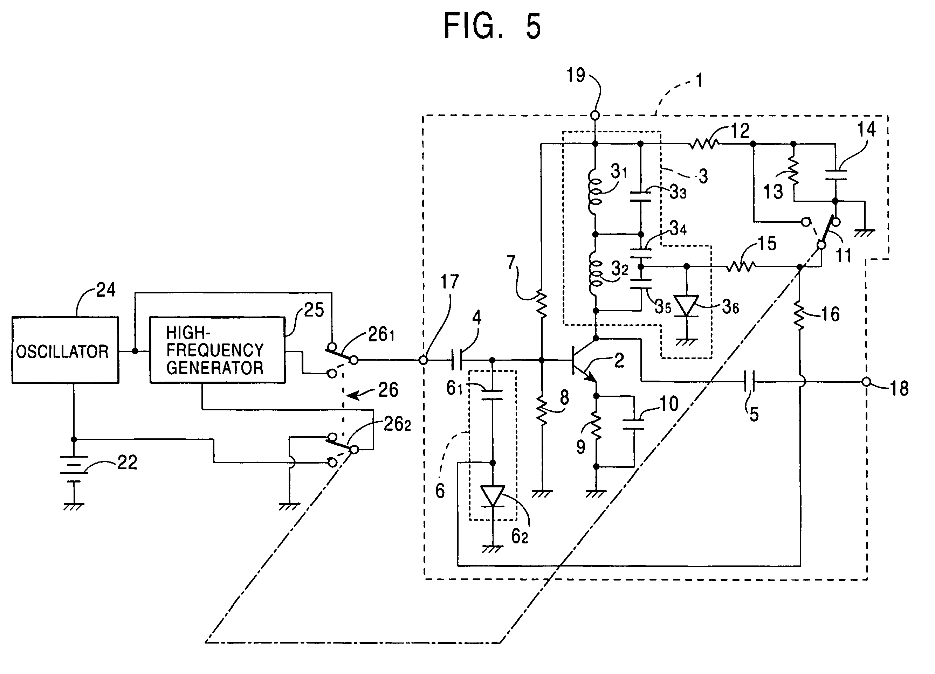

Fig. 5 is a circuit arrangement diagram showing a third embodiment of the frequency characteristic switchable buffer circuit according to the present invention and shows an example in which a second frequency and a first frequency satisfy a basic wave frequency and its secondary harmonic frequency.

As shown in Fig. 5, the frequency characteristic switchable buffer circuit 1 according to the third embodiment is arranged similarly to the buffer circuit 1 according to the first embodiment. However, the front stage of the frequency characteristic switchable buffer circuit 1 according to the third embodiment includes a single voltage-controlled oscillator 24, a second harmonic generator 25, an associating changeover switch 26 composed of two sets of one-circuit two-contacts changeover switches 26₁ and 26₂, and a power supply 22. Thus, the front stage of the buffer circuit 1 of the third embodiment is arranged differently from that of the frequency characteristic switchable buffer circuit 1 according to the first embodiment including the first and second voltage-controlled oscillators 20 and 21.

In the frequency characteristic switchable buffer circuit 1 according to the third embodiment, a changeover switch 11 and the associating changeover switch 26 are switched in association with each other in response to a first or second control signal supplied from a controller (not shown). When the respective movable contacts of the associating changeover switch 26 are switched to solid lines sides, since the power supply 22 connected to the second harmonic generator 25 is isolated therefrom by the changeover switch 26₂, the power supply 22 is connected to only the voltage-controlled oscillator 24, whereby an oscillation signal of the basic wave frequency, for example, an oscillation signal of a second frequency of the 900 MHz is output from the voltage-controlled oscillator 24 and supplied to a signal input terminal 17 of the frequency characteristic switchable buffer circuit 1 through the changeover switches 26₁. In contrast, when the respective movable contacts of the associating changeover switch 26 are switched to dotted line sides, the power supply 22 also is connected to the second harmonic generator 25 through the changeover switch 26₂, whereby the second harmonic generator 25 is put into an operating state.

At that time, the second harmonic generator 25 responds to the basic wave frequency, for example, to the oscillation signal of the second frequency of the 900 MHz band, which is supplied from the voltage-controlled oscillator 24, and outputs its secondary harmonic, for example, an oscillation signal of a first frequency of the 1700 MHz band and the oscillation signal is supplied to the signal input terminal 17 of the frequency characteristic switchable buffer circuit 1 through the changeover switch 26₁.

In the case, the operation which is performed when the oscillation signal of the second frequency of the 900 MHz band is supplied to the signal input terminal 17 of the frequency characteristic switchable buffer circuit 1 according to the third embodiment is the same as the operation which is performed when the oscillation signal of the second frequency of the 900 MHz band is supplied to the signal input terminal 17 of the frequency characteristic switchable buffer circuit 1 according to the first embodiment.

As described above, the frequency characteristic switchable buffer circuit 1 according to the third embodiment also not only can greatly increase a amount of attenuation of the signal component of a spurious frequency to the first frequency when the signal of the first frequency (frequency of the 1700 MHz band) is selected but also can greatly increase an amount of attenuation of the signal component of the frequency of the 1700 MHz band which is the spurious frequency of the signal of the second frequency (frequency of the 900 MHz band) when the signal of the second frequency is selected. Therefore, the buffer circuit 1 can selectively output the signal of the first frequency and the signal of the second frequency in which almost no spurious signal component is contained.

Note that, described in the third embodiment is the example of the frequency characteristic switchable buffer circuit 1 using the above frequency trap circuit 6, it is needless to sat that the frequency characteristic switchable buffer circuit 1 may use the above frequency trap circuit 6'.

Further, while the third embodiment is described as to the example in which the single oscillator is the voltage-controlled oscillator 24, the single oscillator in the present invention is not limited thereto and a single oscillator for generating an oscillation signal of a fixed frequency band may be used.

As described above, according to the present invention, the first switching voltage is supplied to the parallel resonant circuit, and the parallel resonant circuit is caused to perform a parallel resonance at the first frequency so as to selectively output a signal of the first frequency. At that time, when the first switching voltage is supplied also to the frequency trap circuit so that the frequency trap circuit is caused to perform a series resonance at a frequency which is lower than the first frequency so as to form a trap to the low frequency as well as when a trap is generated to the side of a frequency which is higher than the first frequency by the rebound of the formation of the above trap, the signal component of the spurious frequency of the signal of the first frequency is attenuated by these traps. On the other hand, the second switching voltage is supplied to the parallel resonant circuit, and the parallel resonant circuit is caused to perform a parallel resonance at the second frequency so as to selectively output a signal of the second frequency. At that time, when the second switching voltage is supplied also to the frequency trap circuit so that the frequency trap circuit is caused to perform a series resonance at a frequency in the vicinity of 1700 MHz so as to generate a trap to the frequency in the vicinity of 1700 MHz, the signal component of the spurious frequency of the second frequency is attenuated by the trap. As described above, when the signal of the first frequency is selected, an amount of attenuation of the signal component of the spurious frequency of the signal of the first frequency can be increased. In addition, when the signal of the second frequency is selected, an amount of attenuation of the signal component of the spurious frequency of the signal of the second frequency also can be increased. Accordingly, there can be obtained an effect that the first frequency signal and the second frequency signal in which almost no spurious signal component is contained can be selectively output.

## Claims

1. A frequency characteristic switchable buffer circuit, comprising:
an amplifier stage (2, 7, 8);
a parallel resonant circuit (3) which acts as an output load on said amplifier stage;
a frequency trap circuit (6) connected between the input of said amplifier stage and a reference potential; and
a frequency switching voltage generator (11, 12, 13) for selectively generating a first switching voltage and a second switching voltage,
wherein said parallel resonant circuit performs a parallel resonance at a first frequency when the first switching voltage is supplied and performs a parallel resonance at a second frequency which is different from the first frequency when the second switching voltage is supplied, said frequency trap circuit is composed of a series circuit including a diode (6₂) and a capacitor (6₁) and performs a series resonance at the second frequency when the first switching voltage is supplied and performs a series resonance at the first frequency when the second switching voltage is supplied.

2. A frequency characteristic switchable buffer circuit according to claim 1, wherein said frequency trap circuit is arranged such that an inductor (6₅) is connection in series to the series circuit including the diode and the capacitor and a second capacitor (6₆) is connected in parallel to the diode.

3. A frequency characteristics switchable buffer circuit according to claim 1 or 2, wherein the first frequency is supplied from a first oscillator (20) and the second frequency is supplied from a second oscillator (21) the first oscillator and the second oscillator are alternately switched to an operating state and to a non-operating state, when the first oscillator is in the operating state, said frequency switching voltage generator is switched to generate the first switching voltage, and when the second oscillator is in the operating state, said frequency switching voltage generator is switched to generate the second switching voltage.

4. A frequency characteristic switchable buffer circuit according to claim 3, wherein the first oscillator and the second oscillator are voltage-controlled oscillators.

5. A frequency characteristic switchable buffer circuit according to claim 3 or 4, wherein the first oscillator outputs an oscillation signal of the first frequency of a 1700 MHz band used in a DCS mobile communication, and the second oscillator outputs an oscillation signal of the second frequency of a 900 MHz band used in a GSM mobile communication.

6. A frequency characteristic switchable buffer circuit according to claim 1 or 2, wherein the second frequency and the first frequency have a relationship of a basic wave frequency and its harmonic frequency, the second frequency is directly supplied from an oscillator (24) and the first frequency is supplied from a harmonic oscillator (25) to which the second frequency is imposed, when the first frequency is supplied from the oscillator, said frequency switching voltage generator is switched to output the first switching voltage, and when the second frequency is supplied from the harmonic oscillator, said frequency switching voltage generator is switched to output the second switching voltage.

7. A frequency characteristic switchable buffer circuit according to claim 6, wherein the oscillator is a voltage-controlled oscillator

## Patentansprüche

1. Pufferschaltung mit umschaltbarem Frequenzgang, umfassend:
eine Verstärkerstufe (2, 7, 8);
einen Parallelresonanzkreis (3), der als Ausgangslast für die Verstärkerstufe fungiert;
einen Frequenzsperrkreis (6), der zwischen dem Eingang der Verstärkerstufe und einem Referenzpotenzial liegt; und
einen Frequenzumschaltspannungsgeber (11, 12, 13) zum selektiven Erzeugen einer ersten Umschaltspannung und einer zweiten Umschaltspannung,
wobei der Parallelresonanzkreis eine Parallelresonanz bei der ersten Frequenz ausführt, wenn die erste Umschaltspannung geliefert wird, und eine Parallelresonanz bei der zweiten Frequenz, die sich von der ersten Frequenz unterscheidet, ausführt, wenn die zweite Schaltspannung zugeführt wird, wobei der Frequenzsperrkreis sich zusammensetzt aus einer Serienschaltung mit einer Diode (6₂) und einer Kapazität (6₁), und eine Serienresonanz bei der zweiten Frequenz ausführt, wenn die erste Umschaltspannung zugeführt wird, und eine Serienresonanz bei der ersten Frequenz ausführt, wenn die zweite Umschaltspannung zugeführt wird.

2. Pufferschaltung nach Anspruch 1, bei der der Frequenzsperrkreis derart ausgebildet ist, daß eine Induktivität (6₅) in Reihe zu der die Diode und die Kapazität enthaltenden Serienschaltung geschaltet ist, und parallel zu der Diode eine zweite Kapazität (6₆) geschaltet ist.

3. Pufferschaltung nach Anspruch 1 oder 2, bei der die erste Frequenz von einem ersten Oszillator (20) geliefert wird und die zweite Frequenz von einem zweiten Oszillator (21) geliefert wird, wobei der erste Oszillator und der zweite Oszillator abwechselnd in einen Betriebszustand und in einen Ruhezustand geschaltet werden, und, wenn der erste Oszillator sich im Betriebszustand befindet, der Frequenzumschaltspannungsgeber so geschaltet wird, daß er die erste Umschaltspannung erzeugt, und dann, wenn der zweite Oszillator sich im Betriebszustand befindet, der Frequenzumschaltspannungsgeber so geschaltet ist, daß er die zweite Umschaltspannung erzeugt.

4. Pufferschaltung nach Anspruch 3, bei der der erste Oszillator und der zweite Oszillator spannungsgesteuerte Oszillatoren sind.

5. Pufferschaltung nach Anspruch 3 oder 4, bei der der erste Oszillator ein Schwingungssignal mit der ersten Frequenz eines 1700-MHz-Bands, das bei ener DCS-Mobilkommunikation verwendet wird, ausgibt, und der zweite Oszillator ein Schwingungssignal der zweiten Frequenz eines 900-MHz-Bands, welches bei einer GMS-Mobilkommunikation verwendet wird, ausgibt.

6. Pufferschaltung nach Anspruch 1 oder 2, bei der die zweite Frequenz und die erste Frequenz eine Beziehung einer Grundwellenfrequenz und deren Harmonischer aufweisen, wobei die zweite Frequenz direkt von einem Oszillator (24) geliefert wird und die erste Frequenz von einem Harmonischen-Oszillator (25) geliefert wird, dem die zweite Frequenz aufgeprägt wird, wenn die erste Frequenz von dem Oszillator geliefert wird, wobei der Frequenzumschaltspannungsgeber so geschaltet wird, daß er die erste Umschaltspannung liefert, und dann, wenn die zweite Frequenz von dem Harmonischen-Oszillator geliefert wird, der Frequenzumschaltspannungsgeber so geschaltet ist, daß er die zweite Umschaltspannung ausgibt.

7. Pufferschaltung nach Anspruch 6, bei der der Oszillator ein spannungsgesteuerter Oszillator ist.

## Revendications

1. Circuit tampon à commutation de courbe de réponse en fréquence, comprenant :
un étage amplificateur (2, 7, 8) ;
un circuit résonant parallèle (3) qui sert de charge de sortie sur ledit étage amplificateur ;
un circuit réjecteur de fréquence (6) connecté entre l'entrée dudit étage amplificateur et un potentiel de référence ; et
un générateur de tension de commutation de fréquence (11, 12, 13) permettant de générer de manière sélective une première tension de commutation et une deuxième tension de commutation,
dans lequel ledit circuit résonant parallèle effectue une résonance parallèle, à une première fréquence, lorsque la première tension de commutation est fournie et effectue une résonance parallèle, à une deuxième fréquence, qui diffère de la première fréquence, lorsque la deuxième tension de commutation est fournie, ledit circuit réjecteur de fréquence est composé d'un circuit série comportant une diode (62) et un condensateur (61), et effectue une résonance série à la deuxième fréquence lorsque la première tension de commutation est fournie, et effectue une résonance série à la première fréquence lorsque la deuxième tension de commutation est fournie.

2. Circuit tampon à commutation de courbe de réponse en fréquence selon la revendication 1, dans lequel ledit circuit réjecteur de fréquence est agencé de telle sorte qu'une bobine d'induction (6₅) est connectée en série au circuit série comportant la diode et le condensateur, et un deuxième condensateur (6₆) est connecté en parallèle à la diode.

3. Circuit tampon à commutation de courbe de réponse en fréquence selon la revendication 1 ou 2, dans lequel la première fréquence est fournie par un premier oscillateur (20) et la deuxième fréquence est fournie par un deuxième oscillateur (21), le premier oscillateur et le deuxième oscillateur sont commutés en alternance dans un état opérationnel et dans un état non opérationnel, lorsque le premier oscillateur se trouve dans l'état opérationnel, ledit générateur de tension de commutation de fréquence est commuté pour générer la première tension de commutation, et lorsque le deuxième oscillateur est dans l'état opérationnel, ledit générateur de tension de commutation de fréquence est commuté pour générer la deuxième tension de commutation.

4. Circuit tampon à commutation de courbe de réponse en fréquence selon la revendication 3, dans lequel le premier oscillateur et le deuxième oscillateur sont des oscillateurs commandés en tension.

5. Circuit tampon à commutation de courbe de réponse en fréquence selon la revendication 3 ou 4, dans lequel le premier oscillateur sort un signal d'oscillation de la première fréquence d'une bande de 1 700 MHz utilisée dans une communication mobile DSC 1800, et le deuxième oscillateur sort un signal d'oscillation de la deuxième fréquence d'une bande de 900 MHz utilisée dans une communication mobile GSM.

6. Circuit tampon à commutation de courbe de réponse en fréquence selon la revendication 1 ou 2, dans lequel la deuxième fréquence et la première fréquence présentent une relation en termes de fréquence d'ondes de base et sa fréquence harmonique, la deuxième fréquence est directement fournie par un oscillateur (24) et la première fréquence est fournie par un oscillateur harmonique (25) auquel est imposée la deuxième fréquence, lorsque la première fréquence est fournie par l'oscillateur, ledit générateur de tension de commutation de fréquence est commuté pour sortir la première tension de commutation, et lorsque la deuxième fréquence est fournie par l'oscillateur harmonique, ledit générateur de tension de commutation de fréquence est commuté pour sortir la deuxième tension de commutation.

7. Circuit tampon à commutation de courbe de réponse en fréquence selon la revendication 6, dans lequel l'oscillateur est un oscillateur commandé en tension.
